# EUROPEAN PATENT APPLICATION

(11) **EP 2 400 827 A2**
(43) Date of publication of application: **28.12.2011**
(21) Application number: 10193178.0
(22) Date of filing: 30.11.2010
(51) Int. Cl.: H05K 7/20

(54) **Server cabinet with ventilation system**

(30) Priority: 28.06.2010 CN 201010210963
(71) Applicant: Hong Fu Jin Precision Industry (ShenZhen) Co., Ltd., Longhua Town, Bao'an District Shenzhen City Guangdong 518109 (CN); Hon Hai Precision Industry Co., Ltd., Tu-cheng City, Taipei Hsien (TW)
(72) Inventor: Zhou, Hai-Chen, Shenzhen City Guangdong 518109 (CN); Peng, Wen-Tang, Tu-chen City (TW)
(74) Representative: Wilson, Peter

(57) **Abstract**

A server cabinet includes a housing (10) configured for holding plural servers (30) therein, and a ventilation system (40) provided at an open side of the housing. The ventilation system includes an air supply conduit (50) through which airflow can enter other parts of the ventilation system, an air distribution conduit (60) in communication with the air supply conduit, and plural air exhaust conduits (70). Each of the air exhaust conduits is rotatably connected to and communicates with the air distribution conduit. Each air exhaust conduit defines an air outlet therein. The air exhaust conduit is rotatable with respect to an axis of the air distribution conduit in order that the air exhaust conduit can directly face a corresponding server, and the air exhaust conduit is also rotatable about its own axis in order that the air outlet can directly face the corresponding server.

## Description

### BACKGROUND

### 1. Technical Field

This disclosure generally relates to server cabinets, and more particularly to a server cabinet with a ventilation system.

### 2. Description of Related Art

For unified management, many servers can be arranged in a single cabinet. It is well known that the servers in such an arrangement may generate a considerable amount of heat during operation, particularly when they densely occupy the cabinet space. If the heat is not efficiently removed, the servers may suffer damage. Thus, heat dissipation for the cabinet is very important.

What is needed, therefore, is a server cabinet which can overcome the described limitations.

### BRIEF DESCRIPTION OF THE DRAWINGS

Many aspects of the present embodiments can be better understood with reference to the following drawings. The components in the drawings are not necessarily drawn to scale, the emphasis instead placed upon clearly illustrating the principles of the present embodiments. Moreover, in the drawings, like reference numerals designate corresponding parts throughout the various views, and all the views are schematic.

FIG. 1 is an assembled, isometric view of a server cabinet in accordance with one embodiment of the disclosure.

FIG. 2 shows a server being installed in (or removed from) the server cabinet of FIG. 1.

FIG. 3 is an enlarged view of part of a ventilation system of the server cabinet shown in FIG. 1, wherein air exhaust conduits of the ventilation system are rotated to an open position.

FIG. 4 is similar to FIG. 3, but showing the part of the ventilation system viewed from another aspect.

FIG. 5 is an exploded view of the part of the ventilation system shown in FIG. 4.

### DETAILED DESCRIPTION

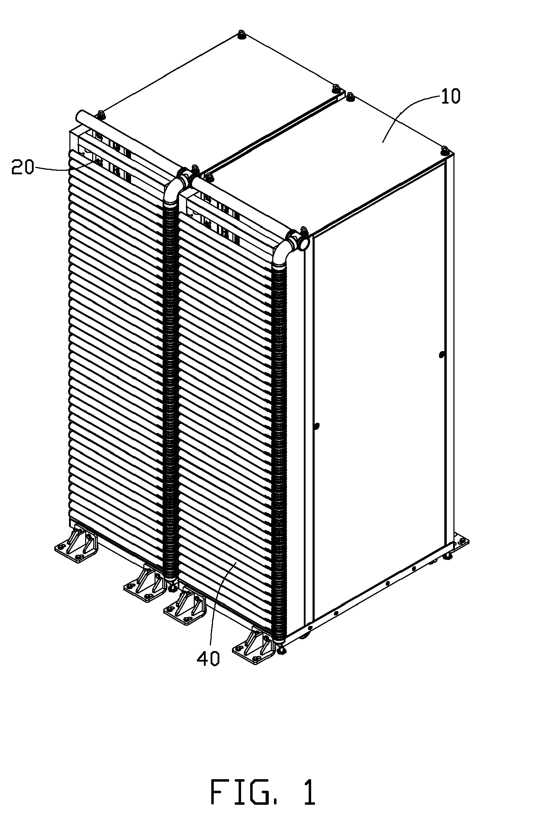

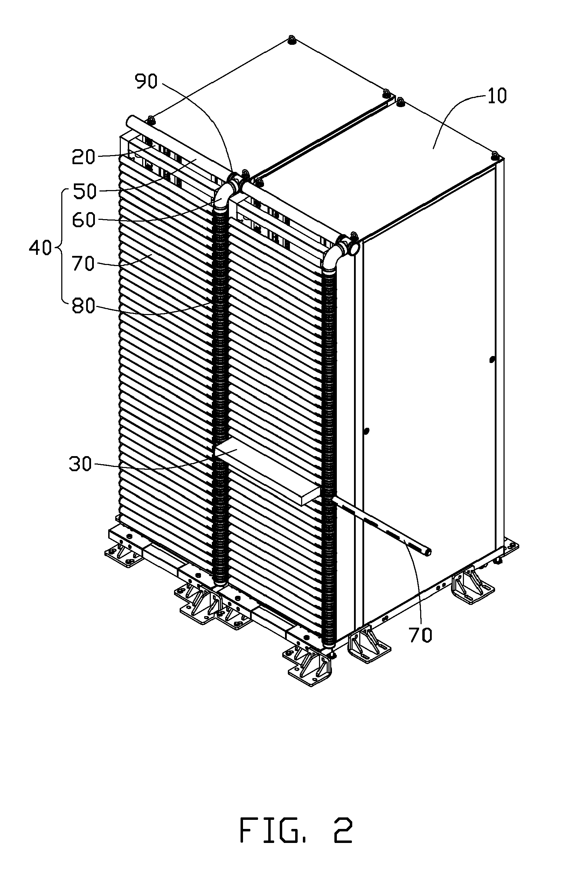

Referring to FIGs. 1 and 2, a server cabinet in accordance with one embodiment of the disclosure is shown. The server cabinet includes a housing 10, a plurality of pairs of rails 20 fixed in the housing 10, a plurality of servers 30 mounted on the rails 20, a system fan (not shown) received in the housing 10, and a ventilation system 40 for guiding airflow toward the servers 30.

The housing 10 has an open front side. The housing 10 is configured according to the number of servers 30 to be received in the housing 10. In this embodiment, there are two columns of servers 30 received in the housing 10, with each of the columns including forty-two stacked servers 30. Each of the servers 30 has a standard rectangular outline, and is movably mounted on a pair of corresponding rails 20.

The ventilation system 40 is arranged at the open side of the housing 10. The ventilation system 40 includes an air supply conduit 50, a plurality of air distribution conduits 60 in communication with the air supply conduit 50, a plurality of air exhaust conduits 70, and a plurality of connecting members 80 interconnecting the air exhaust conduits 70 and the air distribution conduits 60, respectively.

The air supply conduit 50 is horizontally disposed at a top end of the open side of the housing 10. In this embodiment, a length of the air supply conduit 50 substantially equals a width of the housing 10. The air supply conduit 50 has an open end, here its left end as shown in FIG. 2, and a closed end, here its right end as shown in FIG. 2. Alternatively, the air supply conduit 50 can have two open ends, whereby outside cool airflow can enter the air supply conduit 50 rapidly.

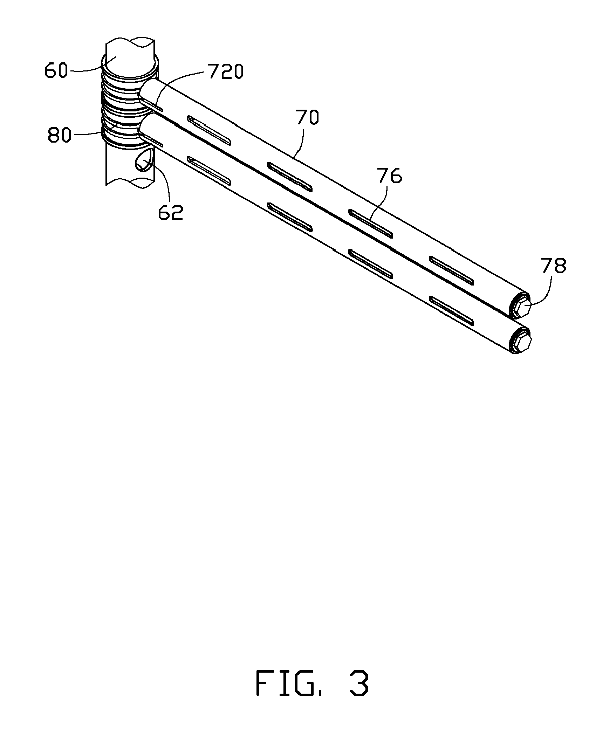

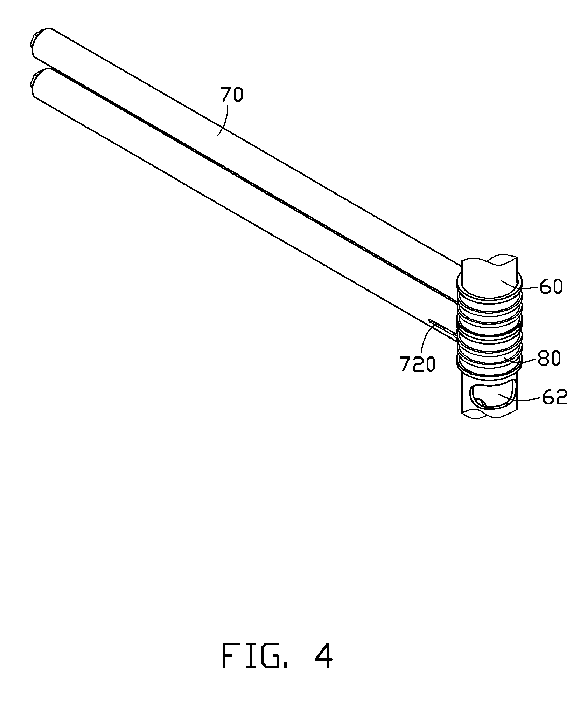

The air distribution conduits 60 are parallel to and spaced from each other. Each of the air distribution conduits 60 corresponds to and is disposed at a lateral side of one column of the servers 30. In this embodiment, there are two air distribution conduits 60, which depend from a central portion and the right end of the air supply conduit 50, respectively. A distance between the air distribution conduits 60 substantially equals a width of each server 30. In this embodiment, each air distribution conduit 60 is disposed at a right lateral side of the corresponding column of servers 30. Each air distribution conduit 60 has a closed bottom end, and an open top end in communication with the air supply conduit 50 via a conduit joint 90. Referring to FIGs. 3 to 5, each air distribution conduit 60 defines two symmetrical columns of through holes 62 on opposite sides thereof, respectively. The number of through holes 62 in each column is the same as the number of servers 30 located adjacent to that column. The through holes 62 are arranged in line parallel to an axis of the air distribution conduit 60, and are evenly spaced apart from each other. A distance between each two adjacent through holes 62 in each column substantially equals a height of each server 30. In this embodiment, forty-two through holes 62 are defined in each column. Each through hole 62 is in the shape of an ellipse with flattened long sides.

The air exhaust conduits 70 are parallel to and spaced from each other. Each of the air exhaust conduits 70 is in communication with a corresponding air distribution conduit 60. Each air exhaust conduit 70 corresponds to one server 30. In this embodiment, two columns (or stacks) of the air exhaust conduits 70 each comprise forty-two air exhaust conduits 70. Each air exhaust conduit 70 includes an open connecting end 72 connected to the air distribution conduit 60, and an opposite free end 74 closed by a seal 78. The connecting end 72 includes two axial slots 720 defined therein, and an annular flange 722 formed on an inner surface thereof. Each air exhaust conduit 70 is slightly shorter than the width of each server 30. Each air exhaust conduit 70 defines a plurality of axial air outlets 76 therein facing a corresponding server 30. In the illustrated embodiment, the axial air outlets 76 are slots, and are aligned with and evenly spaced from each other.

Each of the connecting members 80 includes a sleeve 82, and a branch conduit 84 extending from one side of the sleeve 82. An inner diameter of the sleeve 84 substantially equals an outer diameter of each air distribution conduit 60. The sleeve 82 defines a connecting hole 820 in a joint of the sleeve 82 and the branch conduit 84, for communicating the sleeve 82 with the branch conduit 84. An outer diameter of the branch conduit 84 substantially equals an inner diameter of each air exhaust conduit 70. The branch conduit 84 defines an annular groove 840 in an outer surface thereof adjacent to the sleeve 82, for receiving the flange 722 of a corresponding air exhaust conduit 70 therein.

During assembly of the server cabinet, the connecting members 80 are successively disposed around each air distribution conduit 60, with each connecting member 80 corresponding to two respective opposite through holes 62 of the air distribution conduit 60. The connecting end 72 of each air exhaust conduit 70 is disposed around the branch conduit 84 of a corresponding connecting member 80, with the flange 722 of the air exhaust conduit 70 engaged in the groove 840 of the corresponding connecting member 80. At this time, the connecting end 72 of the air exhaust conduit 70 splays somewhat due to the slots 720 defined in the connecting end 72. Each air exhaust conduit 70 can rotate about its own axis when manipulated by a user, to position the air outlets 76 of the air exhaust conduit 70 to face the corresponding server 30. In addition, each air exhaust conduit 70 in unison with the corresponding connecting member 80 can rotate about an axis of the air distribution conduit 60 when manipulated by a user, to adjust a position of the connecting hole 820 of the corresponding connecting member 80. This adjustment ensures that the connecting hole 820 of the connecting member 80 aligns with a corresponding one of the through holes 62 of the air distribution conduit 60.

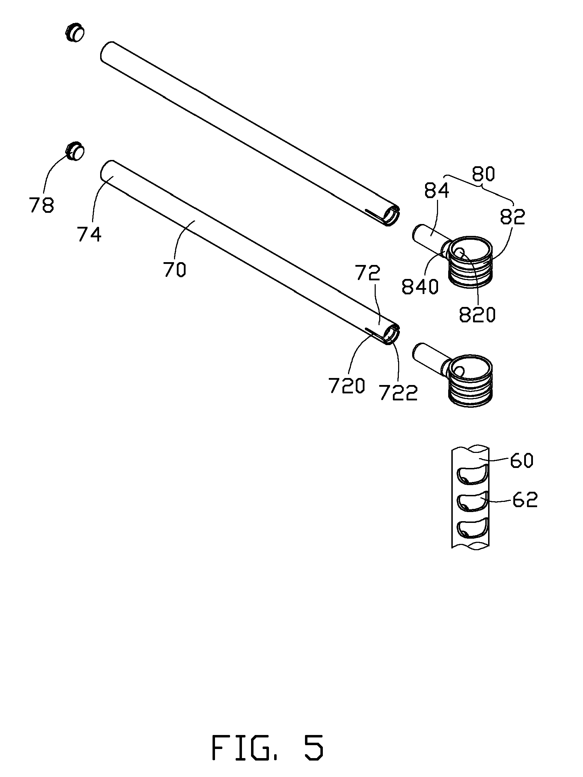

Referring to FIGs. 1 and 5, the through holes 62 of each air distribution conduit 60 are located at the opposite sides of the air distribution conduit 60. The branch conduit 84 of each connecting member 80 and the corresponding air exhaust conduit 70 are disposed at the left side of the corresponding air distribution conduit 60. When all the branch conduits 84 and air exhaust conduits 70 are arranged in this way, the air exhaust conduits 70 are arranged in the two columns. In each column, the air exhaust conduits 70 are parallel to and spaced from each other, and correspond one-to-one to the respective column of servers 30. The air outlets 76 of each air exhaust conduit 70 face the corresponding server 30. The connecting hole 820 of each connecting member 80 communicates with the left through hole 62 of the corresponding air distribution conduit 60, and the right through hole 62 of the corresponding air distribution conduit 60 is sealed by the connecting member 80.

During operation of the server cabinet, cool airflow is drawn into the air supply conduit 50 by the system fan in the housing 10, distributed to the air exhaust conduits 70 through the air distribution conduits 60, and then distributed toward corresponding servers 30 through the air outlets 76 of the air exhaust conduits 70 to dissipate excess heat generated by the servers 30. In addition, referring to FIG. 2, when one of the servers 30 is to be installed or removed, the corresponding air exhaust conduit 70 in unison with the corresponding connecting member 80 can be rotated with respect to the corresponding air distribution conduits 60 to an open position. This allows a considerably simplified process for installation or removal of the server 30.

Furthermore, any of the air exhaust conduits 70 connected with the left-side air distribution conduit 60 can be rotated in unison with the corresponding connecting member 80 180° (degrees) to a position at the right side of the air distribution conduit 60. When the air exhaust conduit 70 reaches such position, the corresponding right through hole 62 of the air distribution conduit 60 communicates with the connecting hole 820 of the connecting member 80, and the left through hole 62 of the air distribution conduit 60 is sealed by the connecting member 80. At this time, if a server 30 is disposed at the right side of the air distribution conduit 60 in alignment with the air exhaust conduit 70, the air exhaust conduit 70 can be rotated about its own axis until the air outlets 76 of the air exhaust conduit 70 face the server 30, thereby providing heat dissipation for the server 30.

It is to be understood, however, that even though numerous characteristics and advantages of the present embodiments have been set forth in the foregoing description, together with details of the structures and functions of the embodiments, the disclosure is illustrative only, and changes may be made in detail, especially in matters of shape, size, and arrangement of parts within the principles of the invention to the full extent indicated by the broad general meaning of the terms in which the appended claims are expressed.

## Claims

1. A server cabinet comprising:
a housing configured for holding a plurality of servers therein; and
a ventilation system provided at an open side of the housing, the ventilation system comprising:
an air supply conduit through which airflow can enter other parts of the ventilation system;
an air distribution conduit in communication with the air supply conduit; and
a plurality of air exhaust conduits, each of the air exhaust conduits rotatably connected to and in communication with the air distribution conduit, each air exhaust conduit defining an air outlet therein, wherein the air exhaust conduit is rotatable with respect to an axis of the air distribution conduit in order that the air exhaust conduit can directly face a corresponding server, and the air exhaust conduit is also rotatable about its own axis in order that the air outlet can directly face the corresponding server.

2. The server cabinet of claim 1, wherein the air distribution conduit comprises a closed end, and an open end in communication with the air supply conduit, and defines a plurality of through holes arranged in line parallel to an axis of the air distribution conduit and spaced apart from each other.

3. The server cabinet of claim 2, wherein the through holes are divided into two columns symmetrically on opposite sides of the air distribution conduit, and a distance between each two adjacent through holes in each column substantially equals a height of each server.

4. The server cabinet of claim 2 or claim 3, further comprising a plurality of connecting members interconnecting the air exhaust conduits and the air distribution conduit, respectively, each of the connecting members comprising a sleeve rotatably disposed around the air distribution conduit, and a branch conduit extending from the sleeve, the sleeve defining a connecting hole in communication with the branch conduit.

5. The server cabinet of claim 4, wherein the branch conduit rotatably connects with a corresponding air exhaust conduit.

6. The server cabinet of claim 5, wherein one of the branch conduit and the corresponding air exhaust conduit defines a groove therein, the other of the branch conduit and the corresponding air exhaust conduit comprises a flange formed thereon, and the flange is received in the groove for connecting the branch conduit with the corresponding air exhaust conduit.

7. The server cabinet of claim 6, wherein one end of the corresponding air exhaust conduit is disposed around the branch conduit, the groove is defined in an outer surface of the sleeve, and the flange is formed on an inner surface of the corresponding air exhaust conduit.

8. The server cabinet of claim 7, wherein the end of the corresponding air exhaust conduit comprises an axial slot defined therein.

9. The server cabinet of any preceding claim, wherein the air supply conduit is disposed at a top end of the housing, the air distribution conduit depends from the air supply conduit, and the air exhaust conduits are parallel to and spaced from each other.

10. The server cabinet of any preceding claim, wherein the air supply conduit comprises a closed end, and an open end through which the airflow can enter the air supply conduit.

11. A ventilation system for dissipating heat generated by a plurality of servers stacked one on the other, the ventilation system comprising:
an air supply conduit through which airflow can enter other parts of the ventilation system;
an air distribution conduit in communication with the air supply conduit; and
a plurality of air exhaust conduits, each of the air exhaust conduits rotatably connected to and in communication with the air distribution conduit, each air exhaust conduit defining an air outlet therein, wherein the air exhaust conduit is rotatable with respect to an axis of the air distribution conduit in order that the air exhaust conduit can directly face a corresponding server, and the air exhaust conduit is also rotatable about its own axis in order that the air outlet can directly face the corresponding server.

12. The ventilation system of claim 11, wherein the air distribution conduit comprises a closed end, and an open end in communication with the air supply conduit, and defines a plurality of through holes arranged in line parallel to an axis of the air distribution conduit and spaced apart from each other, and the through holes are divided into two columns symmetrically on opposite sides of the air distribution conduit.

13. The ventilation system of claim 12, further comprising a plurality of connecting members interconnecting the air exhaust conduits and the air distribution conduit, respectively, each of the connecting members comprising a sleeve rotatably disposed around the air distribution conduit, and a branch conduit extending from the sleeve, the sleeve defining a connecting hole in communication with the branch conduit, the branch conduit being rotatably connected with a corresponding air exhaust conduit.

14. The ventilation system of claim 13, wherein one of the branch conduit and the air exhaust conduit defines a groove therein, the other of the branch conduit and the air exhaust conduit comprises a flange formed thereon, and the flange is received in the groove for connecting the branch conduit with the corresponding air exhaust conduit.

15. The ventilation system of any one of claims 11 to 14, wherein the air distribution conduit depends from the air supply conduit, and the air supply conduit comprises a closed end, and an open end through which the airflow can enter the air supply conduit.
